# EUROPEAN PATENT APPLICATION

(11) **EP 4 804 400 A1**
(43) Date of publication of application: **09.09.2026**
(21) Application number: 25889627.3
(22) Date of filing: 21.05.2025
(51) Int. Cl.: H02S 50/00, H02J 3/38, H03G 1/00, H02S 40/32

(54) **INVERTER AND MAIN CONTROLLER OF SOLAR POWER GENERATION SYSTEM, AND OPERATION METHOD OF SOLAR SYSTEM**

(30) Priority: 08.11.2024 KR 20240158494
(71) Applicant: Hanwha Solutions Corporation, Jung-gu Seoul 04541 (KR)
(72) Inventor: KIM, Min Ho, Seoul 04541 (KR); KIM, Jeong Hwan, Seoul 04541 (KR); BANG, Young Gyun, Seoul 04541 (KR); GONG, Tae Su, Seoul 04541 (KR); LEE, Kang Min, Seoul 04541 (KR); KANG, Hyeon Min, Seoul 04541 (KR)
(74) Representative: Mooser, Sebastian Thomas
(86) International application number: PCT/KR2025/006914
(87) International publication number: WO 2026/100867

(57) **Abstract**

Disclosed is an inverter and a primary controller of a photovoltaic (PV) power generation system, and an operation method of the system. The operation method of the PV power generation system is an operation method performed by the primary controller of the PV power generation system, and the operation method may include: generating a plurality of operation signals having different signal levels; periodically transmitting the plurality of operation signals to a plurality of module level power electronics (MLPE) connected to a plurality of PV panels; and receiving a response signal for an operation signal from at least one **MLPE** that has received at least one of the plurality of operation signals transmitted periodically, and controlling signal levels of the plurality of operation signals based on a result of reception of the response signal.

## Description

### Technical Field

The present disclosure relates to a technique that enables a primary controller of a photovoltaic (PV) power generation system to transmit a plurality of operation signals having different signal levels, so that respective module level power electronics (MLPEs) in the PV power generation system can receive operation signals properly, regardless of a surrounding environment.

### Background Art

A photovoltaic (PV) power generation system may include a module level power electronics (hereinafter, referred to as an MLPE) (or a module-level power conversion device) attached to a PV panel, and a primary controller.

The MLPE may periodically receive an operation signal (e.g., a heartbeat signal) from the primary controller and perform power generation of the PV panel in response to receiving the operation signal. Such an MLPE transmit power generation information including power output, temperature, and failure information of the PV panel to the primary controller, so that a power generation state can be identified.

When the operation signal is not received from the primary controller, the MLPE may stop power generation, so that the PV panel cannot operate properly. As a result, the primary controller may unnecessarily detect an abnormality and perform rapid shutdown (RSD) of the PV power generation system, resulting in a reduction in power generation efficiency.

Therefore, it is important that the operation signal is transmitted to the MLPE properly. However, due to reasons such as a distance between the primary controller and the MLPE and an impedance difference due to component variations, reception sensitivity of the MLPE to the operation signal transmitted from the primary controller is degraded. As a result, it may be difficult for the MLPE to receive the operation signal properly.

### Disclosure of Invention

### Technical Goals

An object of the present disclosure is to provide a photovoltaic (PV) power generation system, in which a primary controller transmits a plurality of operation signals having different signal levels to module level power electronics (MLPEs), so that the operation signals can be properly received by the MLPEs even if the reception sensitivity of the MLPEs to the operation signals is degraded transmitted from the primary controller due to distances from the MLPEs to the primary controller and an impedance difference resulting from component variations.

An object of the present disclosure is to determine that an MLPE not transmitting a response signal for an operating signal during a preset period for error determination among a plurality of MLPES is in an error state, and to generate and display an error state message regarding the MLPE not transmitting the response signal, so that the error state of the MLPE can be accurately and quickly identified and responded.

### Technical Solutions

According to an embodiment of the present disclosure, an operation method of a photovoltaic (PV) power generation system may include: generating a plurality of operation signals having different signal levels; periodically transmitting the plurality of operation signals to a plurality of module level power electronics (MLPE) connected to a plurality of PV panels; and receiving a response signal for an operation signal from at least one MLPE that has received at least one of the plurality of operation signals transmitted periodically, and controlling signal levels of the plurality of operation signals based on a result of reception of the response signal.

In the present disclosure, the controlling of the signal levels of the plurality of operation signals may include: in response to receiving the response signal from the at least one MLPE during a preset period for observation, cumulatively counting a number of responses to an operation signal for each of the plurality of MLPEs; and in response to any MLPE having the number of responses equal to or greater than a preset threshold value, fixing a signal level of an operation signal received by the corresponding MLPE.

In the present disclosure, the controlling of the signal levels of the plurality of operation signals may further include: changing signal levels of remaining operation signals among the plurality of operation signals, excluding the operation signal received by the corresponding MLPE.

In the present disclosure, the generating of the plurality of operation signals may include, based on distances from the plurality of MLPEs to the primary controller, generating the plurality of operation signals having the different signal levels.

In the present disclosure, the operation method may further include determining that an MLPE not transmitting the response signal during a preset period for error determination is in an error state, and generating and displaying an error state message regarding the MLPE not transmitting the response signal.

In the present disclosure, the controlling of the signal levels of the plurality of operation signals may include: changing signal levels of a portion of the plurality of operation signals by adjusting an amplification rate for the operation signal using a digital variable resistor of an amplification unit for amplifying the operation signal, or changing the signal levels of the portion of the plurality of operation signals by controlling a transistor of the amplification unit, or changing the signal levels of the portion of the plurality of operation signals by using a voltage control converter.

According to an embodiment of the present disclosure, a primary controller of a photovoltaic (PV) power generation system may include: a generation unit configured to generate a plurality of operation signals having different signal levels; a communication unit configured to periodically transmit the plurality of operation signals to a plurality of module level power electronics (MLPEs) connected to a plurality of photovoltaic (PV) panels, and receive a response signal for an operation signal from at least one MLPE that has received at least one of the plurality of operation signals transmitted periodically; and a signal control unit configured to control the signal levels of the plurality of operation signals based on a result of reception the response signal.

In the present disclosure, the signal control unit may, in response to receiving the response signal during a preset period for observation, cumulatively count a number of responses to an operation signal for each of the plurality of MLPEs, and in response to any MLPE having the number of responses equal to or greater than a preset threshold value, fix a signal level of an operation signal received by the corresponding MLPE.

In the present disclosure, the signal control unit may change signal levels of remaining operation signals among the plurality of operation signals, excluding the operation signal received by the arbitrary MLPE.

In the present disclosure, the generation unit may generate the plurality of operation signals having different signal levels based on distances from the plurality of MLPEs to the primary controller.

In the present disclosure, the signal control unit may determine that an MLPE not transmitting the response signal during a preset period for error determination is in an error state, and generates and displays an error state message regarding the MLPE not transmitting the response signal.

In the present disclosure, the signal control unit may change signal levels of a portion of the plurality of operation signals by adjusting an amplification rate for the operation signal using a digital variable resistor of an amplification unit for amplifying the operation signal, or changes the signal levels of the portion of the plurality of operation signals by controlling a transistor of the amplification unit, or changes the signal levels of the portion of the plurality of operation signals by using a voltage control converter.

In an embodiment of the present disclosure, an inverter of a photovoltaic (PV) power generation system may include a processor; and a memory operately connected to the processor and configured to store at least one code executed by the processor, wherein the processor generates a plurality of operation signals having different signal levels, periodically transmits the plurality of operation signals to a plurality of Module Level Power Electronics (MLPEs) connected to a plurality of photovoltaic (PV) panels, receives a response signal for an operation signal from at least one MLPE that receives at least one of the plurality of operation signals transmitted periodically, and controls signal levels of the plurality of operation signals based on a result of reception the response signal.

In the present disclosure, wherein the processor may, in response to receiving the response signal from the at least one MLPE during a preset period for observation, cumulatively count a number of responses to an operation signal for each of the plurality of MLPEs, and in response to any MLPE having the number of responses equal to or greater than a preset threshold value, fix a signal level of an operation signal received by the corresponding MLPE.

In the present disclosure, the processor may change signal levels of remaining operation signals among the plurality of operation signals, excluding the operation signal received by the corresponding MLPE.

In the present disclosure, the processor may generate the plurality of operation signals having different signal levels based on distances from the plurality of MLPEs to the inverter.

In the present disclosure, the processor may determine that an MLPE not transmitting the response signal during a preset period for error determination is in an error state, and generates and displays an error state message regarding the MLPE not transmitting the response signal.

In the present disclosure, the processor may change signal levels of a portion of the plurality of operation signals by adjusting an amplification rate for the operation signal using a digital variable resistor of an amplification unit for amplifying the operation signal, or changes the signal levels of the portion of the plurality of operation signals by controlling a transistor of the amplification unit, or changes the signal levels of the portion of the plurality of operation signals by using a voltage control converter

### Effects of Invention

A primary controller may transmit a plurality of operation signals having different signal levels to module level power electronics (MLPEs). Accordingly, operation signals may be properly received by the MLPEs even if reception sensitivity of the MLPEs to operation signal transmitted from the primary controller is degraded due to distances of the MLPEs to the primary controller and an impedance difference resulting from component variations.

An MLPE not transmitting a response signal for an operation signal during a preset period for error determination among a plurality of MLPES may be determined to be in an error state, and an error state message regarding the MLPE not transmitting the response signal may be generated and output. As a result, the error state regarding the MLPE may be identified and responded accurately and quickly. Thus, a photovoltaic (PV) power generation system may increase power generation efficiency by minimizing rapid shutdown (RSD) operations.

### Brief Description of Drawings

FIG. 1 illustrates a photovoltaic (PV) power generation system according to an embodiment.
FIG. 2 illustrates a PV power generation system according to another embodiment.
FIG. 3 is a block diagram illustrating an example of a primary controller included in a PV power generation system according to an embodiment.
FIG. 4 is a flowchart for explaining an example of an operation method of a PV power generation system according to an embodiment.
FIG. 5 is a flowchart illustrating an example of determining an error state in an operation method of a PV power generation system according to an embodiment.
FIG. 6 is a data flowchart for explaining another example of the operation method of a PV power generation system according to an embodiment.
FIGS. 7 and 8 are diagrams illustrating examples of controlling signal levels of a plurality of operation signals in a PV power generation system according to an embodiment.
FIG. 9 is a diagram illustrating a power supply structure of a building where PV panels of a PV power generation system are installed according to an embodiment.
FIG. 10 is a diagram for explaining a plurality of operation signals according to an embodiment.

### Best Mode for Carrying Out the Invention

An operation method of a photovoltaic (PV) power generation system is an operation method performed by a primary controller of the PV power generation system, and the operation method may include: generating a plurality of operation signals having different signal levels; periodically transmitting the plurality of operation signals to a plurality of module level power electronics (MLPE) connected to a plurality of PV panels; and receiving, from at least one MLPE that has received at least one of the plurality of operation signals transmitted periodically, a response signal for the at least one operation signal, and controlling signal levels of the plurality of operation signals based on a result of reception the response signal.

### Mode for Carrying Out the Invention

The terms used in the present disclosure are selected from general terms currently widely used in the art, but these terms may be interpreted differently depending on the context, the intention of a person skilled in the art, or the emergence of new technologies. In addition, in certain cases, there are terms arbitrarily selected by the applicant, in which case the meanings thereof will be described in detail in the corresponding part of the description. Therefore, the terms used in the specification should be defined based on the intended meanings of the terms and the overall context of the specification, rather than the mere names of the terms.

Throughout the entire specification, when a certain part 'includes' a certain constituent element, this means that it does not exclude other constituent elements but may further include other constituent elements, unless specifically stated to the contrary.

In addition, terms including ordinal numbers such as 'first' or 'second' may be used to describe various constituent elements, but the constituent elements should not be limited by these terms. These terms may be used only for the purpose of distinguishing one constituent element from another constituent element.

Embodiments of the present disclosure will be described in detail with reference to the accompanying drawings. However, the embodiments may be implemented in different forms and are not limited to the examples set forth herein.

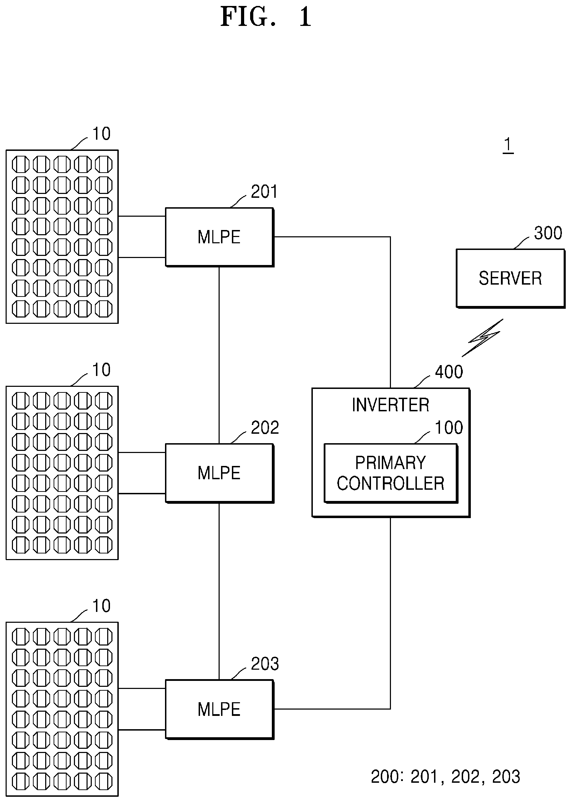

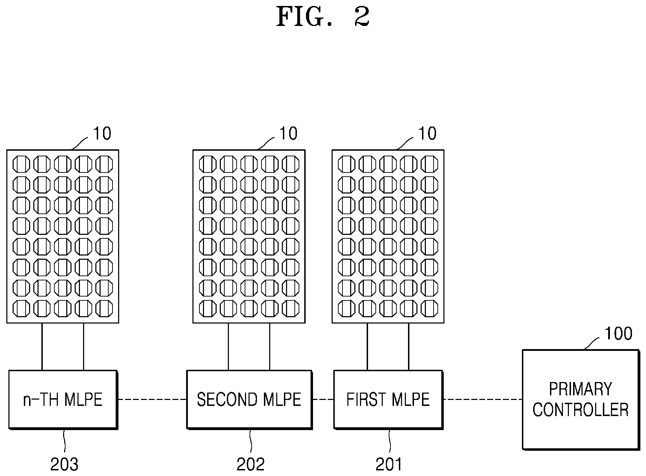

FIG. 1 is a block diagram illustrating an example of a photovoltaic (PV) power generation system according to an embodiment. In addition, FIG. 2 is a block diagram illustrating a PV power generation system according to another embodiment.

Referring to FIG. 1, a PV power generation system 1 may include a plurality of PV panels 10, an inverter 400 including a primary controller 100, a plurality of module level power electronics (MLPEs) 200, and a server 300. Alternatively, the PV power generation system 1 may be configured to include the plurality of PV panels 10, the primary controller 100, the plurality of MLPEs 200, the inverter 400, and the server 300. For example, the primary controller 100 may include a power line communication control board.

For example, the inverter 400 may include the primary controller 100. Alternatively, the inverter 400 may be interposed between the primary controller 100 and a grid (not shown). Here, the inverter 400 may convert direct current (DC) power generated by the plurality of PV panels 10 to alternating current (AC) power and transmit the converted AC power to the grid.

For example, the plurality of PV panels 10 may be connected in at least one of series and parallel. In addition, a single MLPE 200 may be connected to a single PV panel 10, and a single MLPE 200 may be connected to a plurality of PV panels 10.

Each MLPE 200, 201, 202, 203 may be connected to a respective one of the PV panels 10 to perform power generation of the respective PV panel 10 connected thereto based on an operation signal received from the primary controller 100. Each MLPE 200, 201, 202, and 203 may transmit power generation information, including power output, temperature, and failure information of the PV panel 10, to the primary controller 100, so that a power generation state may be identified.

The plurality of MLPEs 200 may receive at least one of a plurality of operation signals having different signal levels periodically (at each preset time) from the primary controller 100, generate a response signal for the received operation signal, and transmit the generated response signal to the primary controller 100. For example, the operation signal may include a heartbeat signal.

The plurality of MLPEs 200 may transmit respective unique information (e.g., serial number) of their own along with response signals, so that the primary controller 100 can identify which MLPEs transmitted the response signal.

At this point, an MLPE 200 may be connected to a PV panel 10 in a one-to-one correspondence as shown in FIG. 1: however, the MLPE 200 may be provided in a many-to-one or many-to-many relationship according to a configuration of the PV power generation system 1, and the present disclosure is not limited thereto.

The MLPE 200 may be provided as a plurality of MLPEs connected in series, and the inverter 400 or the primary controller 100 may be connected at both ends of the plurality of MLPEs 200 connected in series. Alternatively, as illustrated in FIG. 2, the primary controller 100 (or inverter) may be connected to one end of the plurality of MLPEs 200 including first to n-th MLPE (where n is a natural number of 2 or more).

The inverter 400 is installed in a power conversion system (PCS) and configured to perform power conversion to supply power produced by the PV panel 10 to a load or a grid.

The inverter 400 may identify a maximum power point voltage by performing a maximum power point tracking (hereinafter referred to as MPPT) operation for tracking power and voltage at a time when the PV power generation system 1 generates maximum power. The MPPT operation is an algorithm implemented to continuously adjust an impedance of an array composed of a PV panel 10 or a plurality of PV panels 10 so that the PV power generation system 1 operates near a maximum power point thereof when conditions such as sunlight, temperature, and load change.

The inverter 400 may control the MLPEs 200 to perform the MPPT operation, thereby maximizing efficiency of power generation of the PV power generation system 1. In addition, the inverter 400 may monitor an operation state by analyzing various data received from the PV panels 10, the MLPEs 200, the load, and the grid.

The primary controller 100 may generate a plurality of operation signals having different signal levels and periodically transmit the plurality of operation signals to the plurality of MLPEs 200 connected to the plurality of PV panels 10. For example, referring to FIG. 2, a first MLPE 201 located at a shortest distance from the primary controller 100 may receive a plurality of operation signals from the primary controller 100 and transmits the plurality of operation signals to a second MLPE 202, and the second MLPE 202 may receive the plurality of operation signals from the first MLPE 201 and transmits the plurality of operation signals to a third MLPE (not shown).

In this case, a n-th MLPE 203 located at a longest distance from the primary controller 100 may receive operation signals transmitted from the primary controller 100 through the first MLPE 201 to a (n-1)-th MLPE (not shown). At this point, the n-th MLPE 203 may receive the operation signals through multiple MLPES, and the plurality of operation signals having different signal levels may be transmitted from the primary controller 100 even when reception sensitivity for the operation signals transmitted from the primary controller 100 is degraded due to the distance between the n-th MLPE 203 and the primary controller 100 and an impedance difference resulting from component variations among the multiple MLPEs. Accordingly, at least one of the plurality of operation signals may be received reliably. In response to receiving the at least one operation signal, each MLPE may generate a response signal for the at least one operation signal and transmit the response signal to the primary controller 100.

The primary controller 100 may receive, from at least one MLPE that has received at least one of the plurality of operation signals transmitted periodically, a response signal for the at least one operation signal , and may control the signal levels of the plurality of operation signals based on a result of reception the response signal.

The primary controller 100 may collect and output results of reception of response signals received from the plurality of MLPEs 200 or transmits the results to the server 300 (or an administrator's UE), so that an administrator can identify a status of the plurality of MLPEs 200. In this case, transmission and reception of information between the primary controller 100 and the server 300 may be performed in a wired or wireless manner.

The transmission and reception of information between the plurality of MLPEs 200 and the primary controller 100 may be performed using a power line communication (PLC) method. When PLC is used, it is not necessary to use a separate communication cable or a wireless communication technology to transmit and receive information between the plurality of MLPEs 200 and the primary controller 100, thereby facilitating installation and maintenance of the PV power generation system 1.

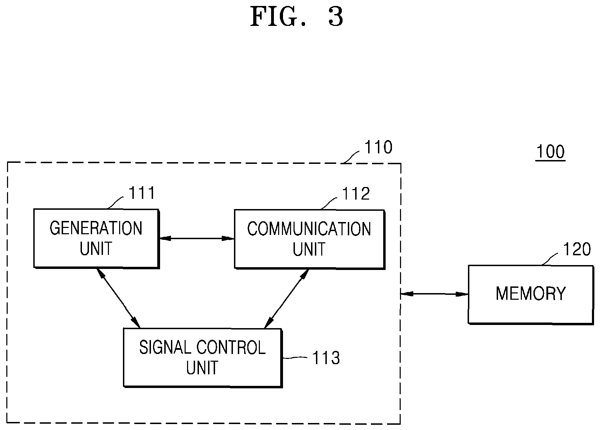

FIG. 3 is a block diagram illustrating an example of a primary controller included in a PV power generation system according to an embodiment.

Referring to FIGS. 1 through 3, the primary controller 100 (or inverter) may be configured to include a processor 110 and a memory 120. In this case, the processor 110 may be configured to include a generation unit 111, a communication unit 112, and a signal control unit 113. However, the aforementioned units are merely functional configurations for describing the operation of the processor 110, and the operation of the present disclosure is not limited by the division of the respective units.

The generation unit 111 may generate a plurality of operation signals having different signal levels. At this point, the generation unit 111 may generate a plurality of operation signals having different signal levels based on distances from the plurality of MLPEs 200 to the primary controller 100 (or inverter).

The generation unit 111 may generate a single operation signal corresponding to a preset signal level, and generate a plurality of operation signals having different signal levels by changing the signal level of the generated single operation signal based on at least one of: a preset adjustment value, distances from the plurality of MLPEs 200 to the primary controller 100 (or inverter), and separation distances between the plurality of MLPEs 200. The distances from the plurality of MLPEs 200 to the primary controller 100, and the separation distances between the plurality of MLPEs 200 may be preset or received from the server 300 (or an administrator terminal which is not shown).

The communication unit 112 may communicate with the plurality of MLPEs 200 connected to the plurality of PV panels 10 or may communicate with the server 300 (or an administrator terminal).

The communication unit 112 may periodically transmit a plurality of operation signals to the plurality of MLPEs 200 (e.g., at each preset time interval) and receive a response signal for an operation signal from at least one MLPE that has received at least one of the plurality of operation signals transmitted periodically. In an embodiment, the communication unit 112 may, for example, sequentially transmit first to fifth operation signals having different signal levels to the plurality of MLPEs 200, and transmit the first to fifth operation signals every five seconds. At this point, the communication unit 112 may: after transmitting a first operation signal, receive, from at least one of the plurality of MLPEs 200, MLPE unique information of the at least one MLPE along with the response signal for the first operation signal; and after transmitting a second operation signal, receive unique information of an MLPE from at least one of the plurality of MLPEs 200, along with a response signal for the second operation signal.

Alternatively, the communication unit 112 may collectively transmit the first to fifth operation signals having different signal levels to the plurality of MLPEs 200 every five seconds. At this point, after transmitting the first to fifth operation signals, the communication unit 112 may receive unique information of an MLPE and a signal level of an operation signal received by the MLPE from at least one of the plurality of MLPEs 200, along with a response signal for at least one operation signal.

The signal control unit 113 may change the signal levels of the operation signals according to an environment by controlling the signal levels of a plurality of operation signals generated by the generation unit 111 based on a reception result associated with response signals from the plurality of MLPEs 200, so that the plurality of MLPEs 200 can receive the operation signals properly even if the reception sensitivity of the MLPEs to the operation signals is degraded.

In response to receiving a response signal from at least one MLPE through the communication unit 112, the signal control unit 113 may cumulatively count a number of responses to an operation signal for each of the plurality of MLPEs, and store the counted number of responses in memory 120. As a preset period for observation elapses, the signal control unit 113 may retrieve, from the memory 120, the counted number of responses to the operation signal for each of the plurality of MLPEs.

When there is any MLPE whose number of responses to the operation signal is equal to or greater than a threshold value during the preset period for observation, the signal control unit 113 may fix the signal level of an operation signal received by the arbitrary MLPE. At this point, the signal control unit 113 may change signal levels of remaining operation signals among a plurality of operation signals, excluding the operation signal received by the arbitrary MLPE.

The signal control unit 113 may change signal levels of a portion of the plurality of operation signals (e.g., the remaining operation signals among the plurality of operation signals, excluding the operation signal received by any MLPE having a number of responses equal to or greater than a preset threshold value) by adjusting an amplification rate for an operation signal using a digital variable resistor of an amplification unit for amplifying an operation signal generated by the generation unit 111, or may change the signal levels of the portion of the plurality of operation signals by controlling a transistor of the amplification unit, or may change the signal levels of the portion of the plurality of operation signals by using a voltage control converter.

In addition, the signal control unit 113 may determine that an MLPE not transmitting a response signal for an operation signal during a period of error determination is in an error state, and may generate and output an error state message regarding the MLPE not transmitting the response signal or transmit the error state message to the server 300 (or an administrator terminal), thereby enabling an administrator to accurately and quickly identify the error state of the MLPE and respond thereto.

The processor 110 may be implemented as an array of multiple logic gates, or may be implemented as a combination of a general-purpose microprocessor and a memory in which a program executable on the microprocessor is stored. For example, the processor 110 may include a general-purpose processor, a central processing unit (CPU), a microprocessor, a digital signal processor (DSP), a controller, a micro-controller, a state machine, and the like. In some environments, the processor 110 may include an application-specific integrated circuit (ASIC), a programmable logic device (PLD), a field programmable gate array (FPGA), and the like. For example, the processor 110 may refer to a combination of processing devices, such as a combination of a digital signal processor (DSP) and a microprocessor, a combination of multiple microprocessors, a combination of one or more microprocessors combined with a digital signal processor (DSP) core, or any other combination of such configurations.

The memory 120, which is the hardware for storing various data processed in the primary controller 100, may be operately connected to the processor 110 and store a program for processing and control of the processor 110.

The memory 120 may include a random access memory (RAM) such as DRAM or SRAM, a read-only memory (ROM), an EEPROM, a flash memory, Blu-ray or other optical disk storage, a hard disk drive (HDD), a solid-state drive (SSD), or a flash memory.

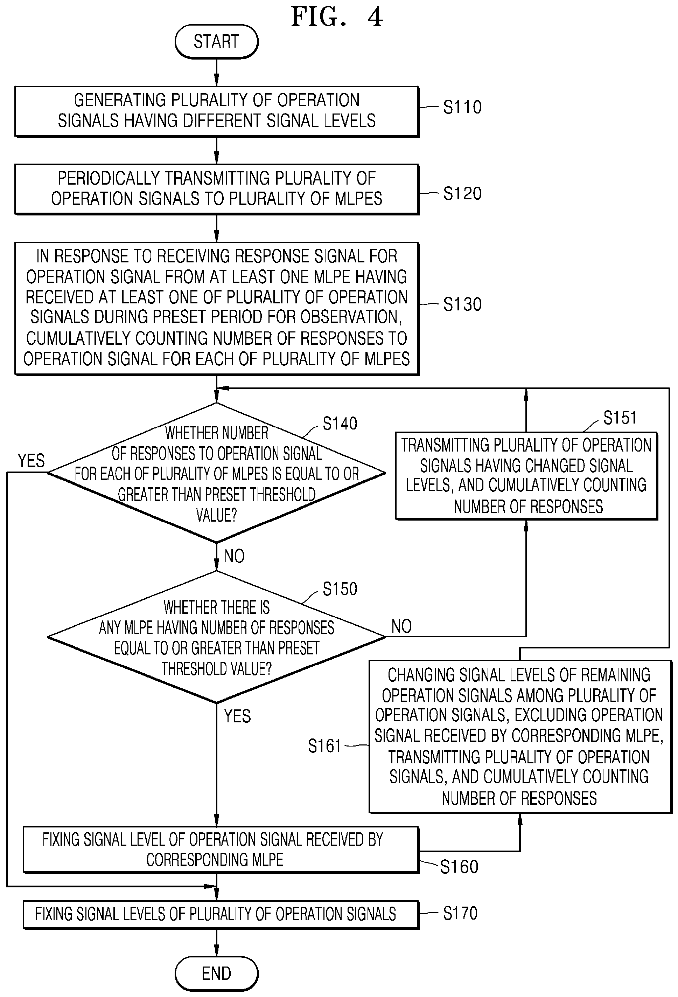

FIG. 4 is a flowchart for explaining an example of an operation method of a PV power generation system according to an embodiment.

For example, the operation method of a PV power generation system, as shown in FIG. 4, may be performed by a primary controller (or inverter).

Referring to FIG. 4, at step S110, the primary controller may generate a plurality of operation signals having different signal levels. The primary controller may generate a single operation signal corresponding to a preset signal level and generate a plurality of operation signals having different signal levels by changing the signal level of the generated single operation signal based on at least one of: a preset adjustment value, distances from a plurality of MLPEs to the primary controller (or inverter) (e.g., a distance between the first MLPE and the primary controller in FIG. 2, a distance between the second MLPE and the primary controller, and the like), and separation distances between the plurality of MLPEs (e.g., a distance between the first MLPE and the second MLPE in FIG. 2, a distance between the (n-1)-th MLPE and the n-th MLPE, and the like).

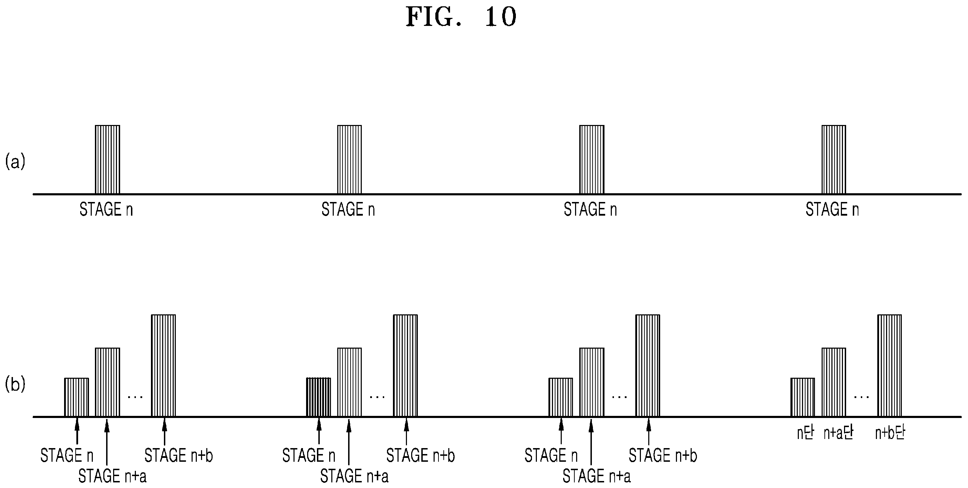

Hereinafter, examples of a plurality of operation signals generated by a primary controller will be described with reference to FIG. 10.

FIG. 10 is a diagram for explaining a plurality of operation signals according to an embodiment.

Referring to FIG. 10(a), operation signals according to a related art all have the same signal level and are transmitted through a single stage. Meanwhile, referring to FIG. 10(b), operation signals according to an embodiment are transmitted such that a plurality of signals having different signal levels are transmitted through a plurality of stages (Stage N, Stage N+A, Stage N+B). Thus, even though an MLPE receives only one of a plurality of operation signals having different signal levels, the MLPE and the primary controller may communicate with each other properly.

Thus, even in a case where reception sensitivity for operation signals transmitted from the primary controller is degraded due to a distance between a n-th MLPE and the primary controller and an impedance difference resulting from component variations among multiple MLPEs, a plurality of operation signals having different signal levels may be transmitted from the primary controller. Accordingly, each MLPE may reliably receive at least one of the plurality of operation signals.

Referring back to FIG. 4, at step S120, the primary controller may periodically transmit the plurality of operation signals to a plurality of MLPES connected to a plurality of PV panels. For example, the primary controller may sequentially transmit first to fifth operation signals having different signal levels every five seconds, or may collectively transmit the first to fifth operation signals.

At step S130, the primary controller may receive a response signal for an operation signal from at least one MLPE that has received at least one of the plurality of operation signals transmitted periodically. When the primary controller sequentially transmits first to fifth operation signals having different signal levels to first to tenth MLPEs, the primary controller may: after transmitting the first operation signal, receive unique information of an MLPE from at least one MLPE among the first to tenth MLPEs along with a response signal for the first operation signal; and after transmitting the second operation signal, receive unique information of an MLPE from at least one MLPE among the first to tenth MLPEs along with a response signal for the second operation signal.

For example, in a case where the primary controller transmits the first to fifth operation signal having different signal levels to the first to the tenth MLPEs, the primary controller may, after transmitting the first to fifth operation signals, receive unique information of an MLPE and a signal level of an operation signal received by the MLPE.

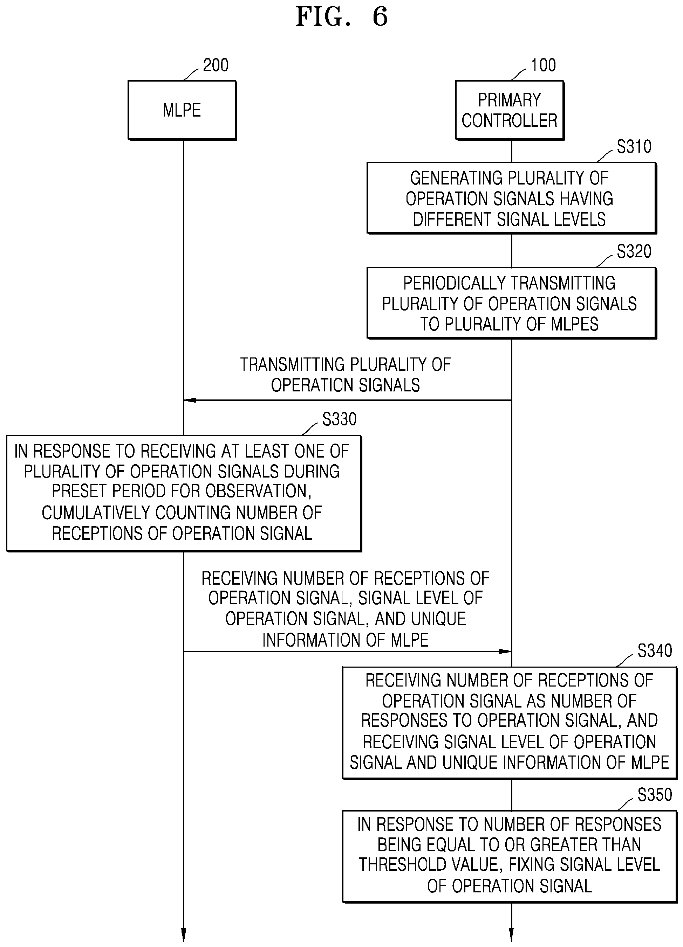

In response to receiving a response signal from at least one MLPE during a preset period for observation (e.g., 60 seconds), the primary controller may cumulatively count a number of responses to an operation signal for each of the plurality of MLPEs based on unique information of an MLPE, which is received along with the response signal, and may store the counted number of responses in a memory. The primary controller may cumulatively count a number of responses based on response signals received from the MLPE in response to an operation signal, but the present disclosure is not limited thereto. For example, a number of receptions, which indicates a cumulative number of receptions of an operation signal by the MLPE, may be received from the MLPE as a number of responses to the operation signal, and a detailed description thereof will be provided later with reference to FIG. 6.

At step S140, the primary controller may determine whether the number of responses for each of the plurality of MLPES is equal to or greater than a preset threshold value. At this point, the primary controller may retrieve, from a memory, a number of responses to an operation signal for each of the plurality of MLPEs, and determine whether the number of responses to the operation signal for each of the plurality of MLPEs is equal to or greater than the present threshold value.

When it is determined at step S140 that a number of responses to an operation signal for each of the plurality of MLPEs is equal to or greater than the preset threshold value, the primary controller may determine that all the MLPEs have received the operation signal properly. Accordingly, at step S170, the primary controller may fix the signal levels of the plurality of operation signals transmitted periodically. For example, in a case where the plurality of MLPES include the first to the tenth MLPE, when it is determined that a number of responses for the first MPLE or a number of responses for the tenth MLPE is equal to or greater than the preset threshold value, the primary controller may fix signal levels of first to fifth operation signals.

When it is not determined at step S140 that the number of responses to an operation signal for each of the plurality of MLPEs is equal to or greater than the preset threshold value, the primary controller may, at step S150, determine whether there is any MLPE whose number of responses to the operation signal is equal to or greater than the preset threshold value.

When it is determined at step S150 that there is no MLPE whose number of responses is equal to or greater than the preset threshold value, the primary controller may change the signal levels of the plurality of operation signals at step S151. The primary controller transmits the plurality of operation signals having changed signal levels, and in response to receiving a response signal for an operation signal from at least one MLPE that has received at least one of the plurality of operation signals, the primary controller may cumulatively count the number of responses to the operation signal for each of the plurality of MLPEs. Then, the primary controller may proceed to step S140.

When it is determined at step S150 that there is any MLPE whose number of responses is equal to or greater than the preset threshold value, the primary controller may fix a signal level of an operation signal received by the corresponding MLPE at step S160. Then, at step S161, the primary controller changes the signal levels of remaining operation signals among the plurality of operation signals, excluding the operation signal received by the arbitrary MLPE. In addition, the primary controller transmits a plurality of operation signals, including an operation signal having a fixed signal level and an operation signal having a changed signal level. In addition, in response to receiving a response signal for an operation signal from at least one MLPE having received at least one operation signal among the plurality of operation signals, the primary controller may cumulatively count a number of responses to the operation signal for each of the plurality of MLPEs. Then, the primary controller may proceed to step S140. For example, the primary controller transmits first to fifth operation signals to first to tenth MLPEs, and when a threshold value is 8 and when a number of responses to the first operation signal for the first MLPE among the first to tenth MLPEs is 10, the number of responses to the first operation signal for the first MLPE is equal to or greater than the threshold value, and therefore, a signal level of the first operation signal received by the first MLPE may be fixed. On the other hand, the primary controller may change the signal levels of the second to fifth operation signals, excluding the first operation signal. At this point, the primary controller may change the signal levels of the second to fifth operation signals based on at least one of: distances from MLPEs (the second MLPE to the tenth MLPE) to the primary controller, and distances between the MLPEs (the second MLPE to the tenth MLPE). For example, as the distances from the MLPEs to the primary controller or the distances between the MLPEs increases, the signal levels of the second to fifth operation signals may be changed to be higher.

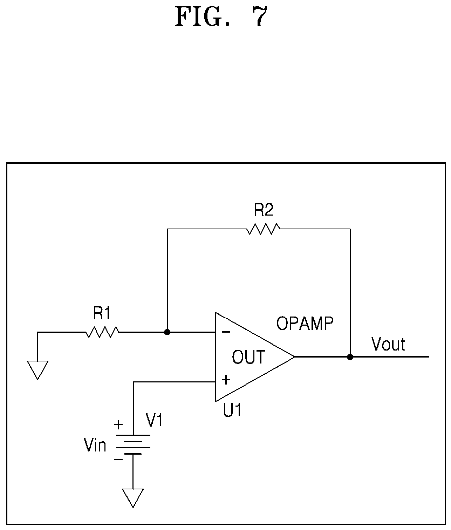

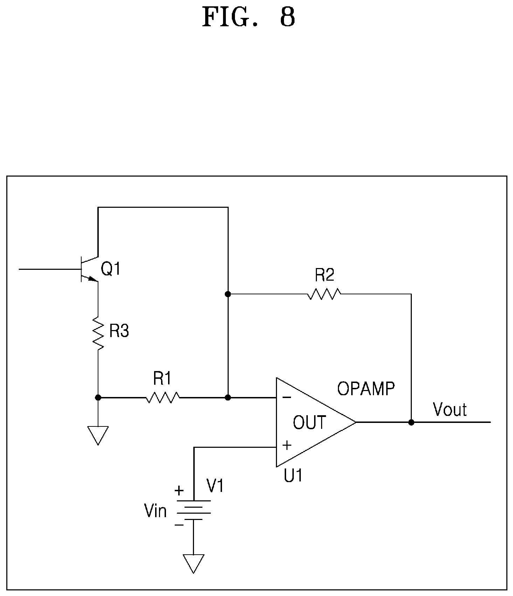

In the case of changing a signal level of an operation signal, the primary controller may change the signal level of the operation signal by adjusting an amplification rate for the operation signal using a digital variable resistor of an amplification unit for amplifying the operation signal, or may change the signal level of the operation signal by controlling a transistor of the amplification unit, or may change the signal level of the operation signal by using a voltage control converter, and a detailed description thereof will be provided in detail with reference to FIGS. 7 and 8.

The primary controller may adaptively control the signal levels of the plurality of operation signals based on a reception result associated with response signals from the plurality of MLPEs, so that operation signals can be properly received from the plurality of MLPEs, regardless of a surrounding environment.

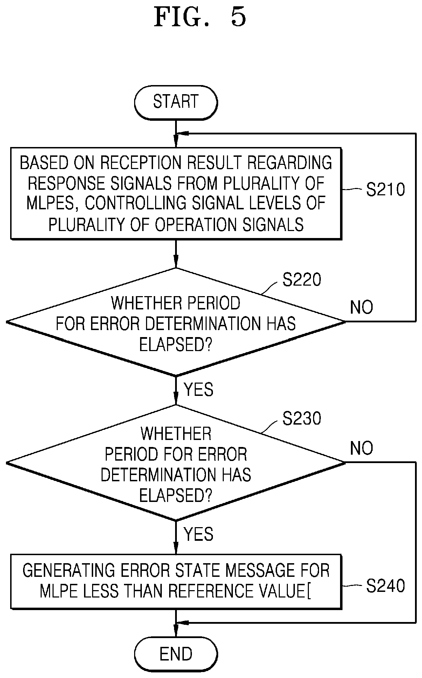

FIG. 5 is a flowchart illustrating an example of determining an error state in an operation method of a PV power generation system according to an embodiment.

Referring to FIG. 5, at step S210, the primary controller may control signal levels of a plurality of operation signals based on a reception result associated with response signals from a plurality of MLPEs (see FIG. 4)

At step S220, the primary controller may, for example, determine whether a preset period for error determination (e.g., 3 minutes) has elapsed based on a time when the plurality of operation signals are first transmitted, and when it is not determined that the period for error determination has elapsed, the primary controller may proceed to step S210. In this case, the period for error determination may be greater than a period for observation (see S130 in FIG. 4).

When it is determined at step S220 that the period for error determination has elapsed, the primary controller may determine whether there is any MLPE whose number of responses is less than a preset reference value, at step S230.

When it is determined at step S230 that there is any MLPE whose number of responses is less than the preset reference value, the primary controller may, at step S240, generate and display an error state message for the corresponding MLPE less than the reference value or transmit the error state message to a server (or administrator terminal), so that the error state of the corresponding MLPE can be identified. In other words, the primary controller may determine that any MLPE not transmitting a response signal for an operation signal during the preset period for error determination is in an error state, and may transmit, to the server (or administer terminal), an error state message regarding the corresponding MLPE not transmitting the response signal, so that the administer can promptly respond to the error state of the MLPE without delay.

FIG. 6 is a data flowchart for explaining another example of an operation method of a PV power generation system according to an embodiment.

Comparing the method shown in FIG. 4 with the method shown in FIG. 6, the method shown in FIG. 6 includes receiving a number of responses to an operation signal from an MLPE, instead of cumulatively counting a number of responses to an operation signal by the primary controller. Except for the above-described difference, the remaining steps are identical between the method shown in FIG. 4 and the method shown in FIG. 6. Therefore, the description of the same configurations in the method shown in FIG. 4 and the method shown in FIG. 6 is omitted.

Referring to FIG. 6, the primary controller 100 may generate a plurality of operation signals having different signal levels and periodically transmit the plurality of operation signals to an MLPE 200 (steps S310 and S320)

In response to receiving at least one of the plurality of operation signals during a preset period for observation, the MLPE 200 may cumulatively count a number of receptions of an operation signal (step S330). The MLPE 200 may transmit the number of receptions of the operation signal, a signal level of the received operation signal, and unique information of the MLPE to the primary controller 100.

The primary controller 100 may receive the number of receptions of the operation signal from the MLPE 200 as a number of responses to the operation signal, and may further receive a signal level of the operation signal and unique information of the MLPE 200 from the MLPE 200.

When the number of responses to the operation signal, which is received from the MLPE 200, is equal to or greater than a preset threshold value, the primary controller 100 may fix the signal level of the operation signal received from the MLPE 200 among the plurality of operation signals periodically transmitted to the MLPE 200.

For example, the MLPE 200 may be configured to include a processor (not shown) and a memory (not shown). Here, when at least one of the plurality of operation signals is received from the primary controller 100, the processor may cumulatively count a number of receptions of a received operation signal and store the counted number of receptions and a signal level of the received operation signal in a memory in association with unique information of the MLPE 200. In addition, the processor may transmit a number of receptions of an operation signal, a signal level of the operation signal, and unique information of an MLPE to the primary controller 100.

FIGS. 7 and 8 are diagrams illustrating examples of controlling signal levels of a plurality of operation signals in a PV power generation system according to an embodiment.

A primary controller (or inverter) of the PV power generation system may control signal levels of a plurality of operation signals based on a reception result associated with response signals from a plurality of MLPEs.

For example, the primary controller may change a signal levels of an operation signal by changing a voltage in an analog to digital converter (ADC) out pin of a micro controller unit (MCU).

In an embodiment, the primary controller may change a signal level of an operation signal by adjusting an amplification rate of an amplification unit (AMP) in a signal transmission stage. As shown in FIG. 7, the primary controller may change a signal level of an operation signal by using a first resistor R1 and a second resistor R2 of the amplification unit (e.g., non-inverting amplifier) as digital variable resistors to adjust an output value Vout, or may change a signal level of an operation signal by turning on/off a transistor TR or Q1 to adjust an output value Vout using a combined resistor of the first resistor R1 and a third resistor R3.

For example, the primary controller may use a buck converter or a boost converter to change a signal level of an operation signal. Alternatively, the primary controller may change a signal level of an operation signal by varying VCC_12V power of a push-pull circuit, for example, using a buck converter or a boost converter.

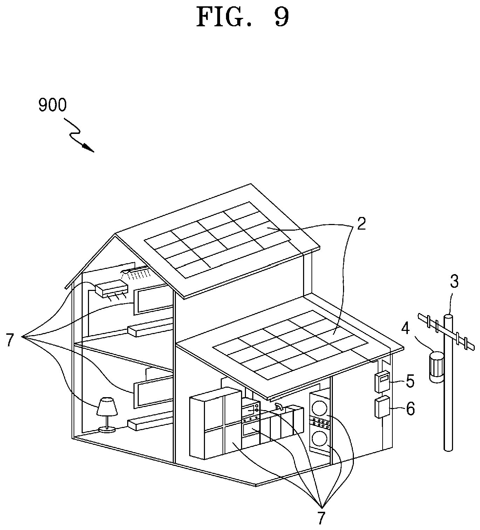

FIG. 9 is a diagram illustrating a power supply structure of a building where PV panels of a PV power generation system according to an embodiment are installed.

Referring to FIG. 9, a PV panel 2 may be installed at a roof of the building to generate energy.

A PV inverter 6 (or a primary controller) may supply generated power into a building 900 by converting energy of the PV panel 2.

Meanwhile, commercial power transmitted through a utility pole 3 may be supplied into the building through a transformer 4.

A plurality of home appliances 7 may operate by selectively receiving at least one of the commercial power and power generated by the PV panel 2. An electricity meter 5 may measure an amount of electricity consumed in the building 900.

In addition, if a separate energy storage system (ESS) is provided, energy of the PV panel 2 may be stored in the ESS.

A plurality of PV panels 2 connected in plural may form a photovoltaic module string. The photovoltaic module string is a collection of a plurality of photovoltaic modules, and may include one output terminal.

Meanwhile, the PV panel 2 may include or be connected to an MLPE.

The PV panel 2 may include a monitoring device (Monitoring Device) for monitoring a state or power output of the PV panel 2 or a rapid shutdown device (RSD) for performing a rapid shutdown function.

In addition, at least one of the plurality of PV panels and the MLPE may include a communication module for power line communication.

According to an embodiment of the present disclosure, a PV power generation system may be provided, in which a primary controller transmits a plurality of operation signals having different signal levels to MLPEs, so that operation signals can be properly received by the MLPEs even if reception sensitivity of the MLPEs to operation signals transmitted from the primary controller is degraded due to distances from the MLPEs to the primary controller and an impedance difference resulting from component variations.

In addition, according to an embodiment of the present disclosure, an MLPE not transmitting a response signal among a plurality of MLPEs during a preset period for error determination may be determined to be in an error state, and an error state message regarding the MLPE not transmitting a response signal may be generated and output, so that the error state of the MLPE can be accurately and quickly identified and processed.

## Claims

1. An operation method performed by a primary controller of a photovoltaic (PV) power generation system, comprising:
generating a plurality of operation signals having different signal levels;
periodically transmitting the plurality of operation signals to a plurality of module level power electronics (MLPE) connected to a plurality of PV panels; and
receiving a response signal for an operation signal from at least one MLPE that has received at least one of the plurality of operation signals transmitted periodically, and controlling signal levels of the plurality of operation signals based on a result of reception of the response signal.

2. The operation method of claim 1, wherein
the controlling of the signal levels of the plurality of operation signals comprises:
in response to receiving the response signal from the at least one MLPE during a preset period for observation, cumulatively counting a number of responses to an operation signal for each of the plurality of MLPEs; and
in response to any MLPE having the number of responses equal to or greater than a preset threshold value, fixing a signal level of an operation signal received by the corresponding MLPE.

3. The operation method of claim 2, wherein
the controlling of the signal levels of the plurality of operation signals further comprises changing signal levels of remaining operation signals among the plurality of operation signals, excluding the operation signal received by the corresponding MLPE.

4. The operation method of claim 1, wherein
the generating of the plurality of operation signals comprises, based on distances from the plurality of MLPEs to the primary controller, generating the plurality of operation signals having the different signal levels.

5. The operation method of claim 1, further comprising:
determining that an MLPE not transmitting the response signal during a preset period for error determination is in an error state, and generating and displaying an error state message regarding the MLPE not transmitting the response signal.

6. The operation method of claim 1, wherein
the controlling of the signal levels of the plurality of operation signals comprises changing signal levels of a portion of the plurality of operation signals by adjusting an amplification rate for the operation signal using a digital variable resistor of an amplification unit for amplifying the operation signal, or changing the signal levels of the portion of the plurality of operation signals by controlling a transistor of the amplification unit, or changing the signal levels of the portion of the plurality of operation signals by using a voltage control converter.

7. A primary controller included in a photovoltaic (PV) power generation system, comprising:
a generation unit configured to generate a plurality of operation signals having different signal levels;
a communication unit configured to periodically transmit the plurality of operation signals to a plurality of module level power electronics (MLPEs) connected to a plurality of photovoltaic (PV) panels, and receive a response signal for an operation signal from at least one MLPE that has received at least one of the plurality of operation signals transmitted periodically; and
a signal control unit configured to control the signal levels of the plurality of operation signals based on a result of reception the response signal.

8. The primary controller of claim 7, wherein
the signal control unit, in response to receiving the response signal during a preset period for observation, cumulatively counts a number of responses to an operation signal for each of the plurality of MLPEs, and in response to any MLPE having the number of responses equal to or greater than a preset threshold value, fixes a signal level of an operation signal received by the corresponding MLPE.

9. The primary controller of claim 8, wherein
the signal control unit changes signal levels of remaining operation signals among the plurality of operation signals, excluding the operation signal received by the arbitrary MLPE.

10. The primary controller of claim 7, wherein
the generation unit generates the plurality of operation signals having different signal levels based on distances from the plurality of MLPEs to the primary controller.

11. The primary controller of claim 7, wherein
the signal control unit determines that an MLPE not transmitting the response signal during a preset period for error determination is in an error state, and generates and displays an error state message regarding the MLPE not transmitting the response signal.

12. The primary controller of claim 7, wherein
the signal control unit changes signal levels of a portion of the plurality of operation signals by adjusting an amplification rate for the operation signal using a digital variable resistor of an amplification unit for amplifying the operation signal, or changes the signal levels of the portion of the plurality of operation signals by controlling a transistor of the amplification unit, or changes the signal levels of the portion of the plurality of operation signals by using a voltage control converter.

13. An inverter of a photovoltaic (PV) power generation system, comprising:
a processor; and
a memory operately connected to the processor and configured to store at least one code executed by the processor,
wherein the processor generates a plurality of operation signals having different signal levels, periodically transmits the plurality of operation signals to a plurality of Module Level Power Electronics (MLPEs) connected to a plurality of photovoltaic (PV) panels,
receives a response signal for an operation signal from at least one MLPE that receives at least one of the plurality of operation signals transmitted periodically, and controls signal levels of the plurality of operation signals based on a result of reception the response signal.

14. The inverter of claim 13, wherein
the processor, in response to receiving the response signal from the at least one MLPE during a preset period for observation, cumulatively counts a number of responses to an operation signal for each of the plurality of MLPEs, and in response to any MLPE having the number of responses equal to or greater than a preset threshold value, fixes a signal level of an operation signal received by the corresponding MLPE.

15. The inverter of claim 14, wherein
the processor changes signal levels of remaining operation signals among the plurality of operation signals, excluding the operation signal received by the corresponding MLPE.

16. The inverter of claim 13, wherein
the processor generates the plurality of operation signals having different signal levels based on distances from the plurality of MLPEs to the inverter.

17. The inverter of claim 13, wherein
the processor determines that an MLPE not transmitting the response signal during a preset period for error determination is in an error state, and generates and displays an error state message regarding the MLPE not transmitting the response signal.

18. The inverter of claim 13, wherein
the processor changes signal levels of a portion of the plurality of operation signals by adjusting an amplification rate for the operation signal using a digital variable resistor of an amplification unit for amplifying the operation signal, or changes the signal levels of the portion of the plurality of operation signals by controlling a transistor of the amplification unit, or changes the signal levels of the portion of the plurality of operation signals by using a voltage control converter.
